# EUROPEAN PATENT SPECIFICATION

(11) **EP 4 053 881 B1**
(45) Date of publication and mention of the grant of the patent: **09.10.2024**
(21) Application number: 20881210.7
(22) Date of filing: 29.10.2020
(51) Int. Cl.: H01L 21/683, H01L 21/02, H01S 5/343, H01L 21/285, H01L 21/28, H01S 5/22, H01S 5/32, H01S 5/02, H01L 33/00, H01L 21/78

(54) **SEMICONDUCTOR ELEMENT AND METHOD FOR PRODUCING SEMICONDUCTOR ELEMENT**
HALBLEITERELEMENT UND HERSTELLUNGSVERFAHREN FÜR DAS HALBLEITERELEMENT
ÉLÉMENT SEMI-CONDUCTEUR ET PROCÉDÉ DE PRODUCTION D'ÉLÉMENT SEMI-CONDUCTEUR

(30) Priority: 29.10.2019 JP 2019196342
(43) Date of publication of application: 07.09.2022
(73) Proprietor: Kyocera Corporation, Kyoto-shi Kyoto 612-8501 (JP)
(72) Inventor: MURAKAWA, Kentaro, Kyoto-shi, Kyoto 612-8501 (JP)
(74) Representative: TBK
(86) International application number: PCT/JP2020/040692
(87) International publication number: WO 2021/085556

(56) References cited:
- CN-A- 109 496 368
- JP-A- 2003 218 389
- JP-A- 2007 189 135
- JP-A- 2008 153 286
- JP-A- 2012 060 023
- JP-A- 2012 060 023
- JP-A- 2012 114 263
- US-A1- 2003 141 508
- US-A1- 2012 064 700
- US-A1- 2021 336 075
- VENNÉGUÈS P ET AL: "Reduction mechanisms for defect densities in GaN using one- or two-step epitaxial lateral overgrowth methods", JOURNAL OF APPLIED PHYSICS, AMERICAN INSTITUTE OF PHYSICS, 2 HUNTINGTON QUADRANGLE, MELVILLE, NY 11747, vol. 87, no. 9, 1 May 2000 (2000-05-01), pages 4175 - 4181, XP012049874, ISSN: 0021-8979, DOI: 10.1063/1.373048

## Description

### Technical Field

The present disclosure relates to a semiconductor element made of a GaN-based semiconductor and a method for manufacturing a semiconductor element.

### Background Art

A semiconductor element and a method for manufacturing a semiconductor element according to a related art are described in Patent Document 1, for example.

### Citation List

### Patent Literature

Patent Document 1: JP 2011-66398 A

Further prior art documents are JP 2012 060023 A showing a semiconductor light-emitting element and manufacturing method of the same, US 2003/141508 A1 showing a semiconductor light emitting device and fabrication method thereof, US 2012/064700 A1 showing a semiconductor substrate, semiconductor device and method of manufacturing a semiconductor substrate, VENNÉGUÈS P ET AL : "Reduction mechanisms for defect densities in GaN using one- or two-step epitaxial lateral overgrowth methods", JOURNAL OF APPLIED PHYSICS, AMERICAN INSTITUTE OF PHYSICS, 2 HUNTINGTON QUADRANGLE, MELVILLE, NY 11747, vol. 87, no. 9, 1 May 2000 (2000-05-01), pages 4175-4181 and CN 109 496 368 A showing a micro-light emitting diode device and method of fabricating the same.

### Summary

A semiconductor element of the present disclosure is defined by claim 1.

A method for manufacturing a semiconductor element of the present disclosure is defined by claim 15.

### Brief Description of Drawings

The objects, features, and advantages of the present disclosure will become more apparent from the following detailed description and drawings.
FIG. 1 is a cross-sectional view schematically illustrating a semiconductor element according to an embodiment of the present disclosure (not covered by the claimed invention).
FIG. 2 is a diagram for describing a method for manufacturing a semiconductor element of the present disclosure.
FIG. 3 is an enlarged photograph showing a cross-section shape near an opening portion of a base substrate 1.
FIG. 4 is an enlarged photograph showing a cross-section shape near an opening portion of the base substrate 1.
FIG. 5A is a cross-sectional view schematically illustrating a state in which a deposition inhibition mask is laminated on a first base surface of the base substrate 1.
FIG. 5B is a cross-sectional view schematically illustrating a state in which a semiconductor layer is formed on the deposition inhibition mask.
FIG. 5C is a cross-sectional view schematically illustrating a state in which a ridge is formed in the semiconductor layer.
FIG. 5D is a cross-sectional view schematically illustrating a state in which an n-type insulating layer is formed on a planar portion of the semiconductor layer having the ridge.
FIG. 5E is a cross-sectional view schematically illustrating a state in which a p-type electrode is laminated on the ridge and the insulating layer.
FIG. 5F is a cross-sectional view schematically illustrating a state in which an electrode pad is laminated on the p-type electrode.
FIG. 5G is a cross-sectional view schematically illustrating a state in which the deposition inhibition mask is removed.
FIG. 5H is a cross-sectional view schematically illustrating a state in which a semiconductor laser element separated from the base substrate is turned over.
FIG. 5I is a cross-sectional view schematically illustrating a state in which an n-type electrode is laminated on a second base surface of the semiconductor laser element.
FIG. 5J is a cross-sectional view schematically illustrating a state in which a pair of resonator surfaces are end surface-coated.
FIG. 5K is a cross-sectional view schematically illustrating a state in which the semiconductor laser element is bonded to a mounting substrate via the n-type electrode.
FIG. 6 is an enlarged photograph of a semiconductor layer viewed from above in FIG. 5H.
FIG. 7 is a cross-sectional view schematically illustrating a semiconductor element according to an embodiment of the present disclosure (not covered by the claimed invention).

### Description of Embodiments (covered or not covered by the claimed invention)

First, a semiconductor element and a configuration as a base of a method for manufacturing a semiconductor element according to the present disclosure will be described.

As described in Patent Document 1 cited above, for example, a semiconductor element and a method for manufacturing a semiconductor element according to a related art have been as follows: a mask layer having a plurality of stripe-shaped openings therein is formed on a base substrate made of a material different from a GaN-based semiconductor, such as a C-plane sapphire substrate, a (111) plane-oriented silicon substrate and the like, and then a GaN-based semiconductor layer is selectively grown in a (0001) plane orientation on a surface of the base substrate exposed from the opening to manufacture a GaN-based semiconductor element.

Electrodes are formed on the GaN-based semiconductor layer manufactured by the above-described method for manufacturing the semiconductor element, and there is room for further improvement, for example, in ohmic contact properties of the electrodes with respect to the GaN-based semiconductor.

Embodiments of the present disclosure (covered or not covered by the claimed invention) will be described below with reference to the drawings. The drawings are schematically depicted for ease of illustration.

### First Embodiment (not covered by the claimed invention)

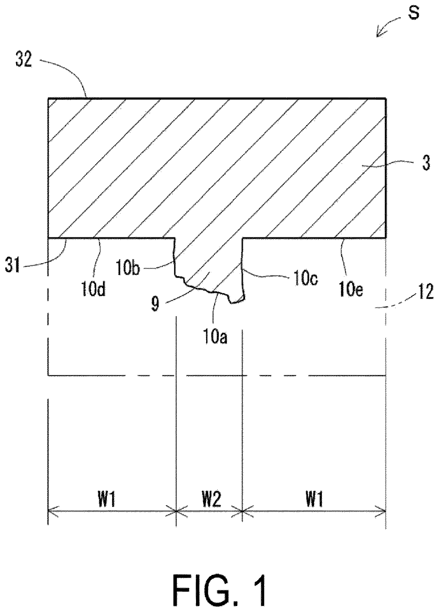

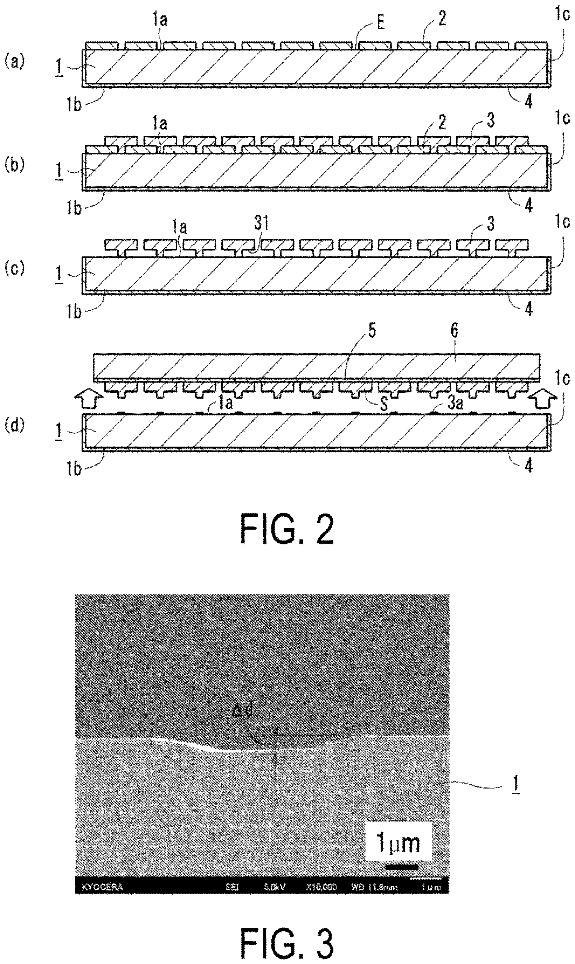

FIG. 1 is a cross-sectional view illustrating a semiconductor element according to an embodiment of the present disclosure. A semiconductor element S of the present embodiment is made of a GaN-based semiconductor and has a crystalline structure obtained by crystal growth in a (0001) plane orientation (a direction perpendicular to a (0001) plane 32) of the GaN-based semiconductor. As illustrated in FIG. 2 described below, there is provided a first surface 31 of a (000-1) plane orientation of the GaN-based semiconductor facing a planar first base surface 1a, which is one main surface of the base substrate 1. The first surface 31 includes a first region W1 in a planar shape and a second region W2 projecting relative to the first region W1. Thus, the first surface 31 includes three crystal planes 10a, 10b, and 10c (the second region W2) having different plane orientations from the (000-1) plane, and two nitrogen polarity surfaces (hereinafter, also referred to as "N planes") 10d and 10e (the first region W1) located in a <11-20> direction (the left-right direction in FIG. 1) of the crystal planes 10a, 10b, and 10c.

As will be described later, such a plurality of crystal planes, where three or more plane orientations include mutually different crystal planes, are composed of a fracture surface 10a, one side surface 10b, and the other side surface 10c of a strip-shaped projecting portion 9 formed by peeling a semiconductor layer 3 from the base substrate 1. The plurality of crystal planes 10a, 10b, and 10c are formed by the projecting portion 9, and therefore are projected from the (000-1) plane in the (000-1) plane orientation (a direction perpendicular to the (000-1) plane).

The projecting portion 9 is achieved as a structure in which the GaN semiconductor projects to the N plane of the semiconductor layer 3, which is a GaN semiconductor obtained by an epitaxial lateral overgrowth (ELO) from the base substrate 1, and therefore the crystal planes other than the N plane (000-1) may be exposed. The projecting portion 9 contains GaN having already been present when forming a deposition inhibition mask, and ohmic contact properties may be improved by adjusting the impurity amount on the base substrate 1 side, for example, adjusting the doping amount of Si.

In the projecting portion 9, as described above, the three crystal planes 10a, 10b, and 10c having different orientations are exposed, which makes it easier to achieve the ohmic contact. The three crystal planes 10a, 10b, and 10c expose crystal planes other than the nitrogen polarity surfaces 10d and 10e, for example, an M plane (1-100), an A plane (11-20), and an R plane (1-102). Then, an n-type electrode 12 is continuously formed over the plurality of crystal planes 10a, 10b and 10c, and the nitrogen polarity surfaces 10d and 10e. This makes it possible to significantly improve the ohmic contact properties with the n-type electrode 12, and improve adhesiveness and stability of the n-type electrode 12. A p-type electrode 14 described below is disposed as a second electrode on the second surface 32 facing the first surface 31 of the semiconductor layer 3.

Ohmic resistance to determine the ohmic contact properties may be measured, for example, by a transmission line model (TLM) method or a circular transmission line model (CTLM) method.

The semiconductor element of the present embodiment may include the projecting portion 9 in a central portion of the first surface 31. In other words, the first surface 31 includes a plurality of the first regions W1 interposing the second region W2 therebetween.

The surface of the first region W1 may include a crystal plane having an identical plane orientation to that of the surface of the second region W2. In this case, for example, by polishing part of the surface of the second region W2 (for example, 10a), the first region W1 and the second region W2 may have a crystal plane of the (000-1) plane orientation.

In the semiconductor element of the present embodiment, a contact region between the first electrode 12 and the first region W1 may be larger than a contact region between the first electrode 12 and the second region W2.

In the contact region between the first electrode 12 and the second region W2, a surface area of a crystal plane having the (000-1) plane orientation or
(1-100) plane orientation may be smaller than a surface area of a crystal plane having a plane orientation different from the (000-1) plane orientation and (1-100) plane orientation.

FIG. 2 is a diagram for describing an embodiment of a method (not covered by the claimed invention) for manufacturing a semiconductor element of the present disclosure. In the drawing, steps (a), (b), (c), and (d), which are manufacturing steps of the semiconductor element, are illustrated.

The method for manufacturing the semiconductor element of the embodiment is conducted by performing a substrate re-use process one or more times in which steps (a) to (d) are repeated.

In FIG. 2, step (a) indicates a mask forming step, and step (b) indicates an element forming step. Step (c) indicates a mask removing step. Step (d) indicates an element separation step.

The base substrate 1 used in common in steps (a) to (d) includes the first base surface 1a, which is one main surface having a flat shape and serving as a start point of the crystal growth of the semiconductor, and a second base surface 1b, which is the other main surface being the back surface of the one main surface and having a flat shape. At least the surface of the first base surface 1a is covered by a nitride semiconductor. The base substrate 1 used in the embodiment is, for example, a gallium nitride (GaN) substrate obtained by being cut out from a GaN single crystal ingot.

The GaN substrate may be an n-type substrate or a p-type substrate in which impurities such as Si are doped in the semiconductor. A substrate with an impurity concentration of approximately equal to or less than 1 × 10¹⁹ cm⁻³ may be used, for example. As the base substrate 1, in addition to the GaN substrate, a substrate may be used in which a GaN semiconductor layer is formed on the front surface of a substrate other than GaN, such as a sapphire substrate, silicon substrate, SiC substrate or the like.

The front surface of the base substrate 1 is not limited to a GaN layer, and any substrate may be used provided that the substrate is composed of a GaN-based semiconductor. In this case, the "GaN-based semiconductor" refers to a semiconductor composed of, for example, AlₓGa_{y}In_{z}N (0 ≤ x ≤ 1 - 1 ≤ y ≤ 1 - 1 ≤ z ≤ 1; x + y + z = 1).

A protective layer 4 may be formed on, excluding the first base surface 1a serving as the start point of the semiconductor crystal growth, the second base surface 1b of the base substrate 1 located on the opposite side (lower side) to the first base surface 1a; and a substrate end surface 1c. The protective layer 4 is formed in order to suppress a change in quality of the base substrate 1 due to the steps described below and decomposition of the nitride semiconductor, or the like. The protective layer 4 may be formed of a layer containing, for example, aluminum oxide or alumina. However, the protective layer 4 may not be formed on the substrate end surface 1c.

In a case where the protective layer 4 is not present, the back surface of the base substrate 1 is likely to be gradually pyrolyzed and changed in quality. As a result, due to the change in quality of the second base surface 1b, which is the back surface of the base substrate 1, a change in thermal emissivity and an in-plane distribution of the thermal emissivity are generated. This causes growth conditions of the semiconductor crystals to be prone to deviating from the optimal conditions, thereby decreasing mass productivity. As in the present embodiment, by covering the second base surface 1b of the base substrate 1 with the protective layer 4, it is possible to suppress the change in quality of the second base surface 1b of the base substrate 1, stabilize the growth conditions of the semiconductor crystals, and improve the mass productivity.

The method for manufacturing the semiconductor element of the first round using the above-described base substrate 1 includes steps (a) to (d) illustrated in FIG. 2. In step (a), a deposition inhibition mask 2 is formed on the first base surface 1a of the base substrate 1. In step (b), the semiconductor layer 3 is formed on the masked first base surface 1a of the base substrate 1. In step (c), the deposition inhibition mask 2 is removed by etching. In step (d), the semiconductor layer 3 is separated from the first base surface 1a of the base substrate 1.

### (1) Step (a) (First Round)

In step (a) as the mask forming step, the deposition inhibition mask 2 for inhibiting the growth of the semiconductor crystal (semiconductor layer 3) is formed in a predetermined pattern on the first base surface 1a of the base substrate 1 (GaN substrate).

As a specific example, an SiO₂ layer having a thickness of approximately 100 to 1000 nm is formed as the deposition inhibition mask 2. The SiO₂ layer is formed as follows. First, silicon dioxide (SiO₂), which is the material of the deposition inhibition mask 2, is laminated on the first base surface 1a by approximately 100 to 1000 nm in thickness by using a plasma chemical vapor deposition (PCVD) method or the like.

Subsequently, unnecessary portions in the SiO₂ layer are removed by photolithography and hydrofluoric acid (HF)-based wet etching, or dry etching using a fluorine-based gas such as CF₄. As a result, the SiO₂ layer with a predetermined pattern may be formed as the deposition inhibition mask 2 on the first base surface 1a.

An exposed surface E located between the masks 2 and seen from a strip-shaped groove (upward opening) is a first crystal growth region in which the first base surface 1a described above is exposed, and is a region serving as a start point of the semiconductor crystal growth in step (b) to be performed subsequently.

An opening width or groove width, which is a width of the exposed surface E in the (11-20) plane orientation, that is, a parallel direction (the left-right direction illustrated in the drawings), is in a range from 2 µm to 20 µm, for example. In the embodiment, a width of the deposition inhibition mask 2 in the parallel direction is set to, for example, a range from 50 µm to 200 µm.

A relationship between the width of the deposition inhibition mask 2 in the parallel direction and the width of the exposed surface E in the parallel direction may be set in consideration of the ratio of the crystal growth rates described below and the thickness of the semiconductor layer 3 to be grown. In other words, a ratio of the crystal growth rate is a ratio between the crystal growth rate in a direction perpendicular to the first base surface 1a of the base substrate 1 and the crystal growth rate in a direction parallel to the first base surface 1a of the base substrate 1, of the semiconductor layer 3 formed in step (b).

The mask pattern of the deposition inhibition mask 2 may be, in addition to a strip shape or a stripe shape, a lattice shape in which a plurality of strip-shaped bodies are arranged to be orthogonal to one another crosswise. Any pattern may be used as long as the pattern is a so-called repeat design (pattern) in which openings partitioned at constant intervals (repeat pitch) are repeated multiple times.

In the deposition inhibition mask 2, unevenness may be formed on the surface by etching or the like. This makes it possible to form unevenness on the back surface of the semiconductor element S separated in step (d), and exhibit an effect of improving ohmic contact properties and adhesiveness between the first surface 31 of the semiconductor element S (the peeling surface after the semiconductor element S is separated) and the n-type electrode 12.

Furthermore, an edge portion region near the substrate end surface 1c of the base substrate 1 on the first base surface 1a of the base substrate 1 is also covered by the deposition inhibition mask 2 in consideration of ease of peeling and separating the semiconductor layer 3, which will be described below. As a result, the semiconductor layer 3 near the edge portion located at the end of the base substrate 1 may also be cleanly and reliably peeled off.

As a mask material constituting the deposition inhibition mask 2, for example, a material containing silicon oxide such as SiO₂ is used. The deposition inhibition mask 2 is preferably made of a material in which the semiconductor layer 3 does not grow starting from the surface of the mask material by vapor phase growth. In addition to the material containing silicon oxide, oxide such as zirconium oxide (ZrOx), titanium oxide (TiOx), aluminum oxide (AlOx) or the like may be used. Alternatively, a transition metal selected from chromium (Cr), tungsten (W), molybdenum (Mo), tantalum (Ta), niobium (Nb), and the like may be used. As a deposition method of the mask material, any method suited to the mask material, such as vapor deposition, sputtering, coating and curing or the like may be used as appropriate.

### (2) Step (b) (First Round)

In step (b) as the element forming step, the semiconductor crystal is grown in such a manner as to spread from the exposed surface E, which is the first crystal growth region, over the adjacent deposition inhibition masks 2 to form the semiconductor layer 3 to serve as an element. In the present embodiment, the semiconductor layer 3 is a nitride semiconductor, and the nitride semiconductor is grown, by epitaxial growth, from the first base surface 1a, beyond an upper edge opening of the groove of the deposition inhibition mask 2, over to the upper side of the deposition inhibition mask 2.

As specific examples, in the element forming step, a vapor phase growth method such as a hydride vapor phase epitaxy (HVPE) method using chloride as a group III (group 13 element) raw material, a metal organic chemical vapor deposition (MOCVD) method using an organic metal as a group III raw material, or a molecular beam epitaxy (MBE) method may be used.

For example, in a case where a GaN layer as the semiconductor layer 3 is grown by MOCVD, first, the base substrate 1 with the pattern-formed deposition inhibition mask 2 is inserted into a reaction chamber of an epitaxial device, and the base substrate 1 is heated while the chamber is supplied with a hydrogen gas and a nitrogen gas, or a mixed gas of hydrogen and nitrogen, and a group V raw material (containing a group 15 element) gas such as ammonia. Then, the temperature is increased up to a predetermined growth temperature, for example, 1050°C to 1100°C.

Subsequently, once the temperature of the base substrate 1 is stable, a group III (containing a group 13 element) raw material such as trimethyl gallium (TMG) is supplied in addition to the gases described above to induce vapor phase growth of the semiconductor layer 3 from the exposed surface E, which is a crystal growth region.

At this time, a desired conductivity type GaN layer may be obtained through adjusting a doping amount by supplying a raw material gas of an n-type impurity such as Si, a p-type impurity such as Mg, or the like. Further, before the growing crystal exceeds the upper edge opening of the groove between the deposition inhibition masks 2 or completely fills the groove, the supply of the raw material is temporarily stopped so as to stop the growth of the semiconductor crystal, and a "frangible portion" that facilitates the peeling of the semiconductor layer 3 described below may be formed as a partial layer or film before the supply of the raw material is restarted.

As an example of the frangible portion, in a case where the GaN layer is subjected to crystal growth, for example, a layer made of a mixed crystal of GaN, BN, AlN, InN, and the like may be formed as the frangible portion between the upper semiconductor layer 3 on the opening side and the lower semiconductor layer 3 on the exposed surface E side in the aforementioned groove.

Alternatively, the semiconductor layer 3 made of AlₓGa_{y}In_{z}N (0 ≤ x ≤ 1 - 1 ≤ y <1 - 1 ≤ z ≤ 1; x + y + z = 1) having a lattice constant different from that of the crystal growth layer may be formed as the frangible portion. Further, a frangible portion having a superlattice structure may be formed by alternately laminating AlGaN layers and GaN layers. The frangible portion may be formed by alternately laminating layers having a large GaN crystal grain size and layers having a small crystal grain size by varying periodically the crystal growth conditions, or by forming layers with different impurity concentrations by varying the concentration of silicon (Si) used as an n-type impurity of GaN.

The semiconductor element S may be separated from the base substrate 1 with ease due to the presence of the frangible portion because a stress is concentrated on the frangible portion to facilitate the generation of cracks when the semiconductor element S is separated and peeled from the base substrate 1. Furthermore, with the above-described frangible portion, by forming the n-type electrode 12 in such a manner as to cover the three crystal planes 10a, 10b, and 10c of the projecting portion 9, which is part of the first surface 31 of the semiconductor element S, the ohmic contact properties may be improved.

In the case where the aforementioned frangible portion is fabricated, GaN is subjected to epitaxial lateral over-growth (ELO) while taking the upper surface (front surface) of the frangible portion as a start point. In the case where the frangible portion is not fabricated, GaN is subjected to epitaxial lateral over-growth while taking the above-described exposed surface E between the masks (the first base surface 1a of the base substrate 1) as a start point. For example, an n+ type GaN layer doped with Si, for example, as an n-type impurity is grown in an island shape in the (0001) plane orientation by the MOCVD method. The thickness of the n+ type GaN layer is, for example, 10 µm, and the impurity concentration thereof is, for example, 1 × 10¹⁸ cm⁻³. A gap in the <11-20> direction between the n+ type GaN layer and the n+ type GaN layer is, for example, approximately 10 µm.

The n+ type GaN layer is grown, for example, at a temperature of 1100°C and a pressure of 30 kPa. For example, during the growth of the n+ type GaN layer, TMG and NH₃ are used as raw material gases, H₂ and N₂ are used as carrier gases, and SiH₄ diluted with nitrogen is used as n-type dopant. One island-shaped n+ type GaN layer is grown from one stripe window.

Next, the crystal growth conditions are adjusted to promote the growth in a longitudinal direction, and the n-type GaN layer is grown on the n+ type GaN layer by the MOCVD method. The thickness of this n-type GaN layer is, for example, 5 µm, and the impurity concentration thereof is, for example, 1 × 10¹⁶ cm⁻³. In this way, a gap in the <11-20> direction of the whole of the n-type GaN layer and the n+ type GaN layer after the growth of the n-type GaN layer is, for example, approximately 5 µm.

After the crystal growth surface exceeds the upper edge of the deposition inhibition mask 2, the semiconductor layer 3 grows in a lateral direction (the left-right direction in the drawings) along the upper surface of the deposition inhibition mask 2. Accordingly, the semiconductor layer 3 may be a semiconductor layer suitable for use in a light-emitting diode (abbreviated as LED) element, a laser diode (abbreviated as LD) element, and the like, where the number of threading dislocations is small.

Then, step (b) (first round) may be ended after each semiconductor layer 3 having started to grow from each exposed surfaces E between the masks makes contact with the adjacent semiconductor layer 3 or before such semiconductor layers overlap each other, or may be ended after the contact of such semiconductor layers is established.

### (3) Step (c) (First round)

After the completion of the above-described step (b) (first round), step (c), which is the mask removing step, is performed. In step (c), the base substrate 1 is taken out from the vapor phase growth device (epitaxial device), and then the deposition inhibition mask 2 is removed by using an etchant that does not substantially damage the grown semiconductor layer 3.

For example, in the case of a mask composed of an SiO₂ film, HF-based wet etching is performed. By etching, each deposition inhibition mask 2 is removed, so that each semiconductor layer 3 has a substantial T-shape in which only a connection portion formed of a thin semiconductor wall or pillar remains on the exposed surface E between the adjacent deposition inhibition masks 2, as illustrated in (c) of FIG. 2. This shape enables easy separation of the semiconductor layer 3.

### (4) Step (d) (First Round)

Step (d), which is the element separation step, is a step in which the semiconductor layers 3 are separated from the base substrate 1 by using a member such as a support substrate 6 including an adhesive layer 5 formed of solder containing a material such as AuSn, a jig, or the like with respect to one surface of each semiconductor layer 3 (the second surface 32 in the present embodiment), thereby obtaining individual semiconductor elements S.

In step (d), for example, the support substrate 6 including the adhesive layer 5 on the lower surface thereof is first caused to face a surface of the base substrate 1 where the semiconductor layers 3 are formed (in other words, the first base surface 1a), and then the adhesive layer 5 is pressed against the semiconductor layers 3 and heated to adhere to the semiconductor layers 3.

Thereafter, an external force is applied to the semiconductor layers 3 adhering to and integrated with the adhesive layer 5 in such a manner as to peel the semiconductor layers 3 upward, so that the semiconductor layers 3 are pulled up from the first base surface 1a of the base substrate 1. As a result, bodies of the semiconductor elements S can be separated.

In step (d), instead of the step of separation using the adhesive layer 5 formed of the solder containing the material such AuSn described above, the separation may be performed by using an adhesive tape such as a dicing tape, a double-sided tape, or the like.

With respect to the base substrate 1 after the semiconductor elements are separated therefrom, damage caused at the time of peeling the semiconductor elements S during the step of epitaxial growth is removed by polishing, and then step (a) as the mask forming step, step (b) as the element forming step, step (c) as the mask removing step, and step (d) as the element separation step similar to those in the manufacture of the first round are performed. As a result, high-quality semiconductor elements S having excellent ohmic contact properties equivalent to those obtained in the manufacture of the first round may be repeatedly manufactured using the same base substrate 1. Examples of types of the damage include pits caused by a reaction between an SiO₂ mask and Ga, surface roughness of GaN caused by the formation, temperature increase, and removal steps of the SiO₂ mask, and dislocations generated by the peeling.

In the step of removing the damage, wet etching or dry etching may be used in addition to polishing. Alternatively, steps (a) to (d) may be repeated by shifting mask opening portions without removing the damage.

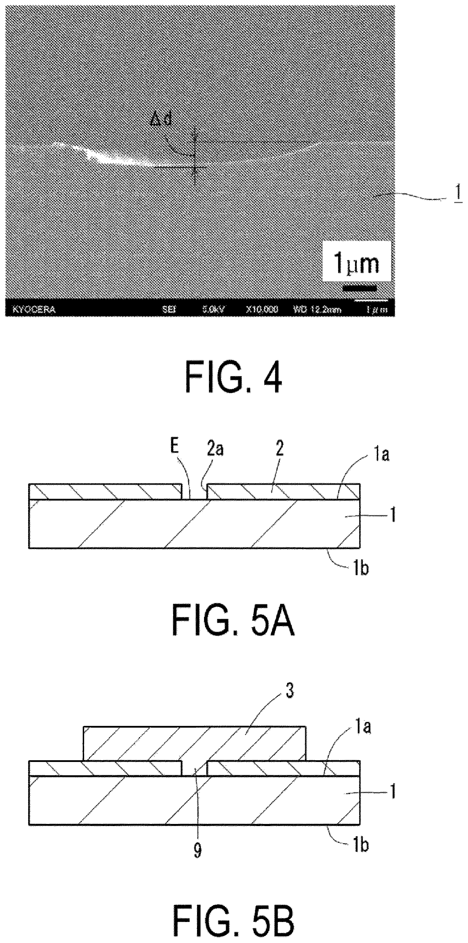

FIGS. 3 and 4 are enlarged photographs each showing a cross-section shape near an opening portion of the base substrate 1. The cross-sectional shape of the opening portion of the base substrate 1 after peeling the semiconductor element S had a recessed shape, and a damage depth Δd thereof was less than or equal to 1 µm .

Therefore, by polishing or wet-etching the first base surface 1a of the post-use base substrate 1 by less than or equal to 1 µm, it is possible to remove lattice defects of the crystal such as the above-described pits, surface roughness, dislocations, and the like.

### Second Embodiment

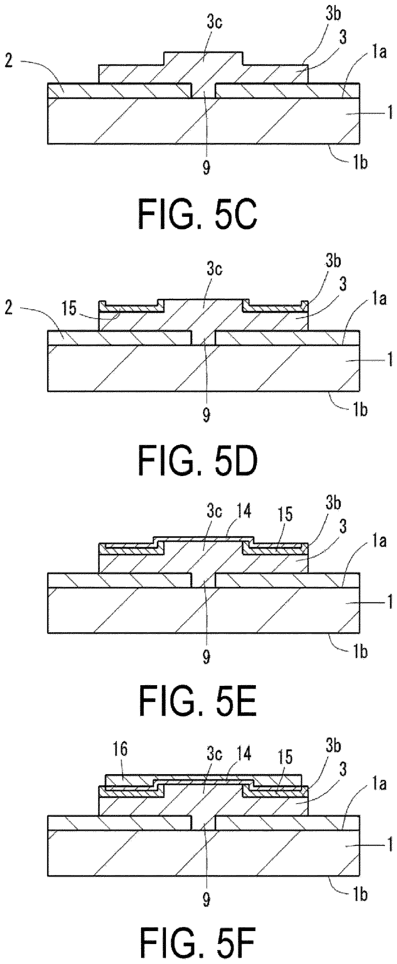

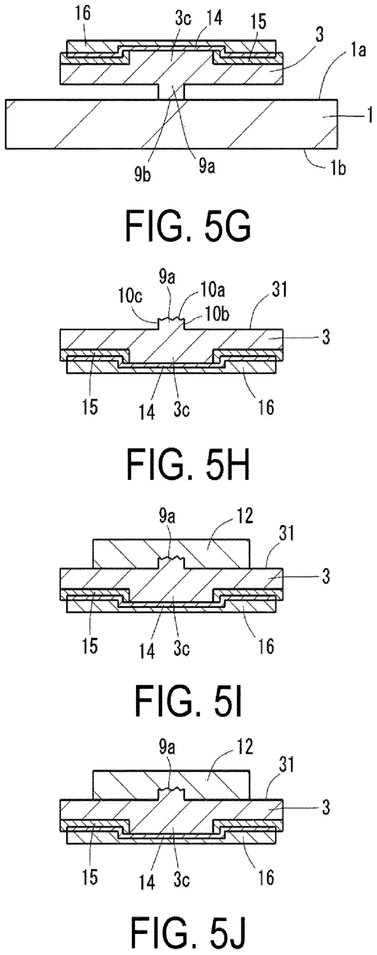

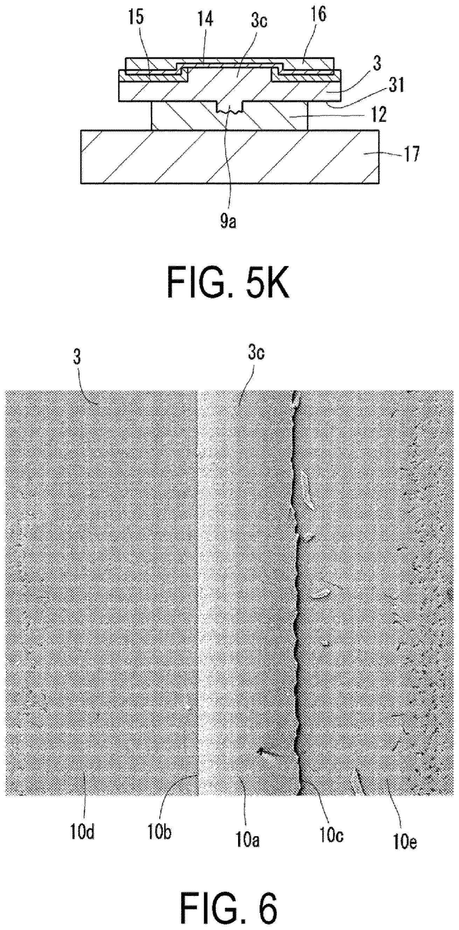

FIGS. 5A to 5K are cross-sectional views schematically illustrating a manufacturing procedure of a semiconductor laser element of a second embodiment according to the present disclosure. FIG. 5A illustrates a state in which the deposition inhibition mask 2 is laminated on the first base surface 1a of the base substrate 1, and FIG. 5B illustrates a state in which the semiconductor layer 3 is formed on the deposition inhibition mask 2. FIG. 5C illustrates a state in which a ridge 3c is formed in the semiconductor layer 3, and FIG. 5D illustrates a state in which an insulating film 15 is formed on a planar portion 3b of the semiconductor layer 3 including the ridge 3c. FIG. 5E illustrates a state in which the p-type electrode 14 is laminated on the ridge 3c and the insulating film 15, and FIG. 5F illustrates a state in which an electrode pad 16 is laminated on the p-type electrode 14. FIG. 5G illustrates a state in which the deposition inhibition mask 2 is removed, and FIG. 5H illustrates a state in which the semiconductor laser element separated from the base substrate 1 is turned over. FIG. 5I illustrates a state in which the n-type electrode 12 is formed on the first surface 31 of the semiconductor layer 3, FIG. 5J illustrates a state in which a pair of resonator surfaces are end surface-coated, and FIG. 5K illustrates a state in which the semiconductor laser element is bonded to a mounting substrate 17 via the n-type electrode 12. FIG. 6 is an enlarged photograph of the semiconductor layer 3 viewed from above in FIG. 5H. The same reference signs are assigned to the portions corresponding to those in the above-described embodiment, and description thereof will not be repeated.

The semiconductor laser element, which is a semiconductor element of the present embodiment, has a substantially rectangular parallelepiped shape with the length being 50 to 1300 µm, the width being 30 to 250 µm, and the height being 5 to 150 µm, is formed in such a manner that two resonator surfaces face each other in a longitudinal direction perpendicular to the page surface of FIG. 5K, and is configured to emit laser beams from one resonator surface.

The base substrate 1 is composed of n-type gallium nitride (GaN), and is a transparent substrate with a thickness of approximately 40 to 600 µm, in which the normal line of the first base surface 1a and a second base surface 1b has an off angle with respect to a c-axis direction or a c-axis, for example. The base substrate 1 may be formed from a GaN wafer having a diameter of approximately two inches. The base substrate 11 is doped with n-type dopant such as Si, and may have electrical conductivity.

The deposition inhibition mask 2 having a plurality of grooves 2a in a stripe shape is laminated on the first base surface 1a of the base substrate 1, as illustrated in FIG. 5A; a nitride semiconductor is epitaxially grown on the deposition inhibition mask 2, and as illustrated in FIG. 5B, the semiconductor layer 3 is laminated. As the deposition inhibition mask 2, an SiO₂ layer having a thickness of approximately 100 to 1000 nm is formed, for example. The SiO₂ layer is formed as follows. First, silicon dioxide (SiO₂), which is the material of the deposition inhibition mask 2, is laminated on the first base surface 1a by approximately 100 to 1000 nm in thickness by using a plasma chemical vapor deposition (PCVD) method or the like. Subsequently, unnecessary portions in the SiO₂ layer are removed by photolithography and hydrofluoric acid (HF)-based wet etching, or dry etching using a fluorine-based gas such as CF₄. With this, the SiO₂ layer with a predetermined pattern can be formed as the deposition inhibition mask 2. From the strip-shaped groove 2a of the deposition inhibition mask 2, the first base surface 1a is partially exposed to become the region E to serve as a start point of the growth of the semiconductor crystal.

As illustrated in FIG. 5C, the semiconductor layer 3 includes the ridge 3c on the opposite side to the base substrate 1. As illustrated in FIG. 5D, the insulating film 15 is provided on the planar portion 3b of the semiconductor layer 3 excluding the upper surface of the ridge 3c. The p-type electrode 14, which is a second electrode, is provided on the semiconductor layer 3. In the present example, the insulating film 15 is provided on the semiconductor layer 3 excluding the ridge 3c, and the p-type electrode 14 is provided on the semiconductor layer 3 with the insulating film 15 interposed therebetween in the above-described portion. As described above, the semiconductor layer 3 and the p-type electrode 14 need not be electrically connected to each other at the entire surfaces thereof, and, as in the present embodiment, a portion other than the ridge 3c under the p-type electrode 14 may be covered with the insulating film 15.

As illustrated in FIG. 5C, the semiconductor layer 3 includes the strip-shaped projecting portion 9 in a region facing the base substrate 1. The first surface 31 of the semiconductor layer 3 is provided with the n-type electrode 12, which is a first electrode, as illustrated in FIG. 5J. In the present example, the n-type electrode 12 is provided on the first surface 31 of the semiconductor layer 3 including the projecting portion 9.

The semiconductor layer 3 is configured such that the thickness is approximately 2 to 5 µm, and a thin film of a nitride semiconductor is laminated. For example, the semiconductor layer 3 is configured such that a first n-type nitride semiconductor layer, a second n-type nitride semiconductor layer, an active layer, a first p-type nitride semiconductor layer, a second p-type nitride semiconductor layer, a third p-type nitride semiconductor layer, and a fourth p-type nitride semiconductor layer are laminated in that order on the first base surface 1a of the base substrate 1. The main component of the above-described semiconductor layer 3 is a mixed crystal of indium nitride (InN), aluminum nitride (AlN), and gallium nitride (GaN) that can be represented by a composition formula of InₓAl_{y}Ga_{1-x-y}N (0 ≤ x ≤ 1 - 1 ≤ y ≤ 1 - 1 ≤ x + y ≤ 1). As n-type impurities included in the semiconductor layer 3, silicon (Si), germanium (Ge), tin (Sn), sulfur (S), oxygen (O), titanium (Ti), zinc (Zr), cadmium (Cd), and the like may be used. As p-type impurities, magnesium (Mg), zinc (Zn), beryllium (Be), manganese (Mn), calcium (Ca), strontium (Sr), and the like may be used. The active layer may have, for example, a multiple quantum well structure in which a barrier layer and a well layer are repeatedly laminated while changing the proportion of components of In and Ga in InGaN. The active layer may or may not contain impurities.

The third p-type nitride semiconductor layer and the fourth p-type nitride semiconductor layer become the ridge 3c formed to project in a strip shape by etching. The width of the ridge 3c is approximately 2 to 20 µm, and the height thereof is approximately -1.3 to 0.6 µm. The ridge 3c is wholly present from one resonator surface to the other resonator surface of the semiconductor layer 3 in a longitudinal direction. Both end surfaces in the longitudinal direction of the ridge 3c are respectively included in the resonator surfaces of the semiconductor laser element. On each of the resonator surfaces, a mirror layer may be formed by a thin film of aluminum acid nitride (AlOₓN_{y} (0 ≤ x ≤ 1 - 1 ≤ y ≤ 1.5)), silicon dioxide (SiO₂), tantalum pentoxide (Ta₂O₅), or the like.

In this manner, the semiconductor layer 3 of the semiconductor laser element is a laminated body in which a plurality of semiconductor layers are laminated, and includes: the semiconductor layer 3 having the first region W1 and the projecting portion 9 (second region W2) projecting relative to the first region W1; and the n-type electrode 12 located over the first region W1 and the second region W2. The first region W1 includes a rough surface region "a" having a larger surface roughness than the other region "b", in a contact region with the n-type electrode 12. The surface roughness may be measured using, for example, an atomic force microscope (AFM). In the present example, the other region b is located between the rough surface region a and the projecting portion 9.

The other region b extends in a strip shape along the projecting portion 9 in the vicinity of the projecting portion 9, and the rough surface region a is located extending in a strip shape along the other region b. Such rough surface region a makes it possible to adjust the surface roughness of part of the first region W1 (rough surface region a) of the semiconductor layer 3 located on the surface of the deposition inhibition mask 2, by roughening at least part of the surface of the deposition inhibition mask 2 disposed on the base substrate 1. Because the surface roughness of part of the first region W1 is large, a preferable connection with the electrode 12 may be established.

Because the surface roughness of part of the first region W1 is large, it is possible to locate a crystal plane in a plane orientation different from the (000-1) plane orientation and the (1-100) plane orientation on the first region W1. That is, the surface of the first region W1 may include a crystal plane having a plane orientation different from the (000-1) plane orientation and the (1-100) plane orientation. In this case, for example, the rough surface region a may include crystal planes such as the A plane (11-20), R plane (1-102) and the like.

Further, in the contact region between the first electrode 12 and the first region W1, a surface area of a crystal plane having the (000-1) plane orientation or (1-100) plane orientation may be smaller than a surface area of a crystal plane having a plane orientation different from the (000-1) plane orientation and (1-100) plane orientation.

In a direction perpendicular to the longitudinal direction of the projecting portion 9 (parallel direction), in the case where the total width of the first region W1 is denoted as B0, the width of the other region b is denoted as B1, and the width of the rough surface region a is denoted as B2, the width B 1 of the other region b is in a range of 10% or more and 80% or less of the total width B0, and the width B2 of the rough surface region a is in a range of 20% or more and 90% or less of the total width B0.

In the present example, the semiconductor layer 3, which is a laminated body, is formed of a GaN-based semiconductor, and the other region a and the rough surface region b of the first region W1 are two nitrogen polarity surfaces (hereinafter, also referred to as "N planes") located in a <11-20> direction (left-right direction in FIG. 5C) of the above-described three crystal planes 10a, 10b, and 10c of the first surface 31.

The surface roughness of the other region b is 0.05 nm or more and less than 1 nm, and the surface roughness of the rough surface region a is 1 nm or more and less than 1000 nm.

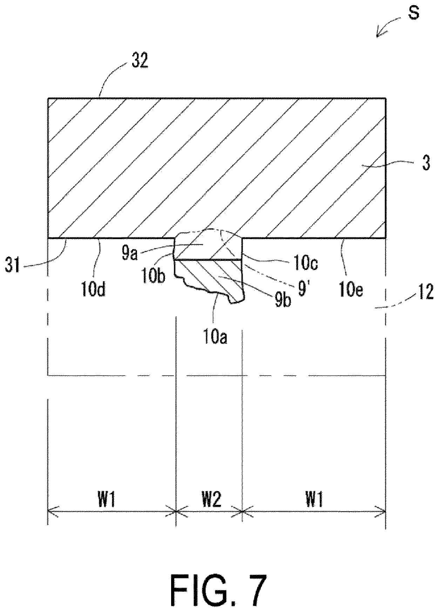

As illustrated in FIG. 7, the projecting portion 9 includes a first projecting region 9a located on the semiconductor layer 3 side, and a second projecting region 9b located on the base substrate 1 side (a tip side of the projecting portion 9) relative to the first projecting region 9a. The impurity concentration of the second projecting region 9b is less than that of the first projecting region 9a. The first projecting region 9a may be located on the tip side of the projecting portion 9 relative to the second projection region 9b. The first projecting region 9a and the second projecting region 9b constitute a connection portion in a state being connected to each other. The above-described projecting portion 9 may be formed by separating the semiconductor layer 3 together with part of the base substrate 1, from the base substrate 1.

The dislocation density of the second projecting region 9b may be less than that of the first projecting region 9a. The projecting portion 9 is formed by the crystal growth of the nitride semiconductor on the exposed surface E of the first base surface 1a of the base substrate 1, and refers to a state in which the first projecting region 9a and the second projecting region 9b are connected. In this case, the dislocation density of the first projecting region 9a is, for example, in a range of 1 × 10⁴ or more and 1 × 10⁷ or less and the dislocation density of the second projecting 9b is, for example, in a range of 1 × 10³ or more and 5 × 10⁶ or less. Dislocation defects of the connection portion may be greater in number than the dislocation defects of the second projecting region 9b. The dislocation defects of the connection portion may be greater in number than the dislocation defects of the first projecting region 9a. The dislocation density may be adjusted by varying the growth conditions during the growth of the semiconductor layer 3. In other words, the dislocation density may be larger than that in the regions located above and below the connection portion.

The density of dislocations which are crystal defects of the semiconductor crystal may be adjusted by appropriately controlling the growth conditions of the semiconductor layer 3.

The length of the first projecting region 9a in a projecting direction of the projecting portion 9 may be larger than the length of the second projecting region 9b in the projecting direction of the projecting portion 9. The surface area of the first projecting region 9a may be larger than the surface area of the second projecting region 9b.

The entire surface of the first region W1 may be a rough surface, or only part of the region may be the rough surface. In a case where only part of the region is the rough surface, the rough surface region a may be located near the projecting portion 9. That is, in the parallel direction, a surface area of a region between one outer edge of the rough surface region a and the projecting portion 9 may be smaller than a surface area of a region between the other outer edge of the rough surface region a and an outer edge of the semiconductor layer 3.

A plurality of the rough surface regions a may be located on both sides of the projecting portion 9. In the present example, the projecting portion 9 is located between two rough surface regions a. In this case, the n-type electrode 12 may be configured to cover only one region of the rough surface regions a on either side of the projecting portion 9.

In the above-described embodiment, a configuration in which the semiconductor layer 3 includes the strip-shaped projecting portion 9 has been described, but in another embodiment, a configuration may be employed in which, instead of the projecting portion 9, there is provided a strip-shaped recessed portion 9' (second region W2) being recessed relative to the first region W1, where the first surface 31 is flattened. In such a configuration as well, because at least one of the first region W1 and the second region W2 includes a crystal plane having a plane orientation different from the (000-1) plane orientation and the (1-100) plane orientation, it is possible to achieve a crystal plane having excellent ohmic contact properties with respect to an electrical conductor layer such as an electrode, and improve joining reliability between the layers. By adjusting a direction in which a stress is generated when the semiconductor layer 3 is peeled off, the recessed portion 9' may be formed as depicted by an imaginary line in FIG. 7, and a crystal plane 10a may be achieved.

The semiconductor element S of the present embodiment includes the first surface 31 in the (000-1) plane orientation of the GaN-based semiconductor facing the planar first base surface 1a as one main surface of the base substrate 1. The first surface 31 includes the planar first region W1 and the second region W2 recessed relative to the first region W1. Thus, the first surface 31 includes a plurality of crystal planes (second region W2) having plane orientations different from the (000-1) plane, and two nitrogen polarity surfaces (hereinafter, also referred to as "N planes") 10d and 10e (first region W1) located in the <11-20> direction (left-right direction in FIG. 1) of these crystal planes. Further, the plurality of crystal planes expose crystal planes
other than the nitrogen polarity surfaces 10d and 10e, for example, the M plane (1-100), A plane (11-20), and R plane (1-102).

According to the semiconductor element of the present disclosure, because the semiconductor element includes a planar portions 10a to 10e having excellent ohmic contact properties, high joining reliability may be obtained without a step of performing a process to improve ohmic contact properties between the semiconductor layer 3 and the insulating film 15 and between the semiconductor layer 3 and the n-type electrode 12, and the semiconductor element may be achieved as, for example, a semiconductor laser element. This makes it possible to improve productivity of the semiconductor elements and provide the semiconductor elements having excellent mass productivity.

According to the method for manufacturing the semiconductor element of the present disclosure, it is possible to achieve the semiconductor element including a surface having excellent ohmic contact properties without increasing the number of steps. This makes it possible to facilitate the mass productivity of semiconductor elements having the high joining reliability.

### Reference Signs List

1 Base substrate
1a First base surface
1b Second base surface
1d Edge portion
2 Deposition inhibition mask
3 Semiconductor layer
3a Remaining portion of semiconductor layer
3b Planar portion
3c Ridge
4 Protective layer
5 Adhesive layer
6 Support substrate
9 Connection portion
9a First projecting region
9b Second projecting region
10a, 10b, 10c Plurality of crystal planes
12 n-type electrode
14 p-type electrode
15 Insulating layer
16 Mounting substrate
31 First surface
32 Second surface
E Exposed surface
S Semiconductor element

## Claims

1. A semiconductor element (S) comprising gallium nitride, the semiconductor element comprising:
a semiconductor layer (3) comprising a first surface (31) comprising a first region (W1) and a second region (W2) that is a projecting portion (9) having a strip shape and projecting relative to the first region or a recessed portion having a strip shape and being recessed relative to the first region,
wherein, of the first surface, at least one of surfaces of the first region and the second region comprises a crystal plane comprising a plane orientation different from a (000-1) plane orientation and a (1-100) plane orientation, and
the semiconductor layer further comprises a second surface (32) opposite to the first surface, and
the second surface has a ridge (3c).

2. The semiconductor element according to claim 1,
wherein the first surface, at least one of the surfaces of the first region and the second region comprises a crystal plane comprising a plane orientation different from a plane orientation facing a plane orientation of the second surface.

3. The semiconductor element according to claim 1 or 2,
wherein the projecting portion comprises three or more crystal planes of mutually different plane orientations.

4. The semiconductor element according to claim 3,
wherein one of the three or more crystal planes of the projecting portion is a crystal plane comprising the (000-1) plane orientation and the (1-100) plane orientation.

5. The semiconductor element according to any one of claims 1 to 4,
wherein the surface of the first region comprises a crystal plane comprising a plane orientation different from a plane orientation of the surface of the second region.

6. The semiconductor element according to any one of claims 1 to 4,
wherein the surface of the first region comprises a crystal plane comprising an identical plane orientation to a plane orientation of the surface of the second region.

7. The semiconductor element according to any one of claims 1 to 6, further comprising:
a first electrode disposed in the first region and the second region of the first surface.

8. The semiconductor element according to claim 7,
wherein the first electrode is an n-type electrode.

9. The semiconductor element according to any one of claims 1 to 8,
wherein
the semiconductor element further comprises a second electrode disposed on the second surface.

10. The semiconductor element according to any one of claims 1 to 9,
wherein the surface of the first region takes the (000-1) plane orientation.

11. The semiconductor element according to any one of claims 1 to 10,
wherein the surface of the second region takes the (000-1) plane orientation.

12. The semiconductor element according to any one of claims 1 to 11,
wherein the first surface comprises the second region and a plurality of the first regions sandwiching the second region.

13. The semiconductor element according to claim 7 or 8,
wherein, in a contact region between the first electrode and the second region, a surface area of a crystal plane comprising the (000-1) plane orientation or the (1-100) plane orientation is smaller than a surface area of a crystal plane comprising a plane orientation different from the (000-1) plane orientation and the (1-100) plane orientation, and
the recessed portion comprises a plurality of crystal planes of mutually different plane orientations.

14. The semiconductor element according to any one of claims 1 to 13,
wherein the first region further comprises a rough surface region.

15. A method for manufacturing a semiconductor element (S), the method comprising the steps of:
preparing a substrate (1);
forming a mask (2) on a first substrate surface (1a) of the substrate while exposing a region (E) to serve as a start point of growth of a semiconductor layer (3) before forming the semiconductor layer,
forming the semiconductor layer (3) comprising gallium nitride on the exposed region of the first substrate surface of the substrate;
removing the mask such that the semiconductor layer comprises a projecting portion (9); and
peeling the semiconductor layer including the projecting portion from the substrate by applying an external force to the semiconductor layer and the substrate,
wherein, when peeling the semiconductor layer from the substrate, the semiconductor layer is peeled in such a manner that a peeling surface forms a crystal plane comprising a plane orientation different from a (000-1) plane orientation and a (1-100) plane orientation.

16. The method for manufacturing the semiconductor element according to claim 15,
wherein when peeling the semiconductor layer from the substrate, the semiconductor layer is peeled together with a part of the substrate connected to the semiconductor layer.

17. The method for manufacturing the semiconductor element according to claim 16,
wherein when peeling the semiconductor layer from the substrate, the semiconductor layer is peeled in such a manner that a part of the semiconductor layer remains on the substrate.

18. The method for manufacturing the semiconductor element according to any of claims 15 to 17,
wherein, of a surface of the mask, a surface on which the semiconductor layer grows comprises unevenness.

19. The method for manufacturing the semiconductor element according to any one of claims 15 to 18, wherein,
the semiconductor layer is formed by epitaxially growing the semiconductor layer starting from the substrate,
the semiconductor layer comprises a first surface comprising a first region and a second region adjacent to the first region,
wherein the second region is the peeling surface formed when the semiconductor layer is being peeled from the substrate.

20. The semiconductor element according to claim 1,
wherein the projecting portion comprises a first projecting region and a second projecting region with a smaller impurity concentration than the first projecting region.

21. The semiconductor element according to claim 20
wherein the first projecting region is located at a tip relative to the second projecting region.

## Patentansprüche

1. Halbleiterelement (S), das Galliumnitrid aufweist, wobei das Halbleiterelement aufweist:
eine Halbleiterschicht (3), die eine erste Oberfläche (31), die ein erstes Gebiet (W1) und ein zweites Gebiet (W2), das ein hervorstehender Anteil (9) mit einer Streifenform ist und relativ zu dem ersten Gebiet hervorsteht, oder ein zurückgesetzter Anteil mit einer Streifenform ist und relativ zu dem ersten Gebiet zurückgesetzt ist, aufweist,
wobei von der ersten Oberfläche zumindest eine der Oberflächen des ersten Gebiets und des zweiten Gebiets eine Kristallebene, die eine Ebenenorientierung, die verschieden von einer (000-1) Ebenenorientierung und einer (1-100) Ebenenorientierung ist, aufweist, aufweist, und
die Halbleiterschicht ferner eine zweite Oberfläche (32) gegenüber der ersten Oberfläche aufweist, und
die zweite Oberfläche einen Grat (3c) aufweist.

2. Halbleiterelement nach Anspruch 1,
wobei von der ersten Oberfläche zumindest eine der Oberflächen des ersten Gebiets und des zweiten Gebiets eine Kristallebene aufweist, die eine Ebenenorientierung, die verschieden von einer Ebenenorientierung ist, die einer Ebenenorientierung der zweiten Oberfläche zugewandt ist, aufweist.

3. Halbleiterelement nach Anspruch 1 oder 2,
wobei der hervorstehende Anteil drei oder mehr Kristallebenen von zueinander verschiedenen Ebenenorientierungen aufweist.

4. Halbleiterelement nach Anspruch 3,
wobei eine der drei oder mehr Kristallebenen des hervorstehenden Anteils eine Kristallebene, die die (000-1) Ebenenorientierung und die (1-100) Ebenenorientierung ist, ist.

5. Halbleiterelement nach einem der Ansprüche 1 bis 4, wobei die Oberfläche des ersten Gebiets eine Kristallebene, die eine Ebenenorientierung, die verschieden von einer Ebenenorientierung der Oberfläche des zweiten Gebiets ist, aufweist, aufweist.

6. Halbleiterelement nach einem der Ansprüche 1 bis 4,
wobei die Oberfläche des ersten Gebiets eine Kristallebene, die eine identische Ebenenorientierung zu einer Ebenenorientierung der Oberfläche des zweiten Gebiets aufweist, aufweist.

7. Halbleiterelement nach einem der Ansprüche 1 bis 6, das ferner aufweist:
eine erste Elektrode, die in dem ersten Gebiet und dem zweiten Gebiet der ersten Oberfläche angeordnet ist.

8. Halbleiterelement nach Anspruch 7,
wobei die erste Elektrode eine Elektrode des n-Typs ist.

9. Halbleiterelement nach einem der Ansprüche 1 bis 8, wobei
das Halbleiterelement ferner eine zweite Elektrode, die auf der zweiten Oberfläche angeordnet ist, aufweist.

10. Halbleiterelement nach einem der Ansprüche 1 bis 9,
wobei die Oberfläche des ersten Gebiets, die (000-1) Ebenenorientierung annimmt.

11. Halbleiterelement nach einem der Ansprüche 1 bis 10,
wobei die Oberfläche des zweiten Gebiets die (000-1) Ebenenorientierung annimmt.

12. Halbleiterelement nach einem der Ansprüche 1 bis 11,
wobei die erste Oberfläche das zweite Gebiet und eine Vielzahl der ersten Gebiete, die das zweite Gebiet einbetten, aufweist.

13. Halbleiterelement nach Anspruch 7 oder 8,
wobei in einem Kontaktgebiet zwischen der ersten Elektrode und dem zweiten Gebiet eine Oberfläche einer Kristallebene, die die (000-1) Ebenenorientierung oder die (1-100) Ebenenorientierung aufweist, kleiner als eine Oberfläche einer Kristallebene, die eine Ebenenorientierung, die verschieden von der (000-1) Ebenenorientierung und der (1-100) Ebenenorientierung ist, ist, und
der zurückspringende Anteil eine Vielzahl von Kristallebenen von zueinander unterschiedlichen Ebenenorientierungen aufweist.

14. Halbleiterelement nach einem der Ansprüche 1 bis 13,
wobei das erste Gebiet ferner ein raues Oberflächengebiet aufweist.

15. Verfahren zum Herstellen eines Halbleiterelements (S), wobei das Verfahren die Schritte aufweist:
Vorbereiten eines Substrats (1);
Bilden einer Maske (2) auf einer ersten Substratoberfläche (1a) des Substrats, wobei ein Gebiet (E), das als ein Startpunkt eines Wachsens einer Halbleiterschicht (3) dient, vor einem Bilden der Halbleiterschicht außen liegt,
Bilden der Halbleiterschicht (3), die Galliumnitrid aufweist, auf dem außenliegenden Gebiet der ersten Substratoberfläche des Substrats;
Entfernen der Maske, sodass die Halbleiterschicht einen hervorstehenden Anteil (9) aufweist; und
Ablösen der Halbleiterschicht einschließlich dem hervorstehenden Anteil von dem Substrat durch Anlegen einer externen Kraft an die Halbleiterschicht und das Substrat,
wobei, wenn die Halbleiterschicht von dem Substrat abgelöst wird, die Halbleiterschicht in solch einer Weise abgelöst wird, das eine Ablöseoberfläche eine Kristallebene, die eine Ebenenorientierung, die verschieden von einer (000-1) Ebenenorientierung und einer (1-100) Ebenenorientierung ist, aufweist, bildet.

16. Verfahren zum Herstellen des Halbleiterelements nach Anspruch 15,
wobei, wenn die Halbleiterschicht von dem Substrat abgelöst wird, die Halbleiterschicht zusammen mit einem Teil des Substrats, das mit der Halbleiterschicht verbunden ist, abgelöst wird.

17. Verfahren zum Herstellen des Halbleiterelements nach Anspruch 16,
wobei, wenn die Halbleiterschicht von dem Substrat abgelöst wird, die Halbleiterschicht auf solch eine Weise abgelöst wird, das ein Teil der Halbleiterschicht auf dem Substrat bleibt.

18. Verfahren zum Herstellen des Halbleiterelements nach einem der Ansprüche 15 bis 17,
wobei von einer Oberfläche der Maske eine Oberfläche, auf der die Halbleiterschicht wächst, eine Unebenheit aufweist.

19. Verfahren zum Herstellen des Halbleiterelements nach einem der Ansprüche 15 bis 18, wobei
die Halbleiterschicht durch epitaktisches Wachsen der Halbleiterschicht gebildet wird, wobei von dem Substrat gestartet wird,
die Halbleiterschicht eine erste Oberfläche, die ein erstes Gebiet und ein zweites Gebiet, das dem ersten Gebiet benachbart ist, aufweist, aufweist,
wobei das zweite Gebiet die Ablöseoberfläche ist, die gebildet wird, wenn die Halbleiterschicht von dem Substrat abgelöst wird.

20. Halbleiterelement nach Anspruch 1,
wobei der hervorspringende Anteil ein erstes hervorspringendes Gebiet und ein zweites hervorspringendes Gebiet mit einer kleineren Verunreinigungskonzentration als das erste hervorspringende Gebiet aufweist.

21. Halbleiterelement nach Anspruch 20,
wobei das erste hervorspringende Gebiet an einer Spitze relativ zu dem zweiten hervorspringenden Gebiet lokalisiert ist.

## Revendications

1. Élément semi-conducteur (S) comprenant du nitrure de gallium, l'élément semi-conducteur comprenant :
une couche semi-conductrice (3) comprenant une première surface (31) comprenant une première région (W1) et une deuxième région (W2) qui est une partie saillante (9) ayant une forme de bande et faisant saillie par rapport à la première région ou une partie en retrait ayant une forme de bande et étant en retrait par rapport à la première région,
dans lequel, de la première surface, au moins une des surfaces de la première région et de la deuxième région comprend un plan cristallin comprenant une orientation de plan différente d'une orientation de plan (000-1) et d'une orientation de plan (1-100), et
la couche semi-conductrice comprend en outre une deuxième surface (32) opposée à la première surface, et
la deuxième surface présente une arête (3c).

2. Élément semi-conducteur selon la revendication 1,
dans lequel la première surface, au moins l'une des surfaces de la première région et de la deuxième région comprend un plan cristallin comprenant une orientation de plan différente d'une orientation de plan faisant face à une orientation de plan de la deuxième surface.

3. Élément semi-conducteur selon la revendication 1 ou 2,
dans lequel la partie saillante comprend trois plans cristallins ou plus d'orientations de plan mutuellement différentes.

4. Élément semi-conducteur selon la revendication 3,
dans lequel l'un des trois plans cristallins ou plus de la partie saillante est un plan cristallin comprenant l'orientation de plan (000-1) et l'orientation de plan (1-100).

5. Élément semi-conducteur selon l'une des revendications 1 à 4,
dans lequel la surface de la première région comprend un plan cristallin comprenant une orientation de plan différente d'une orientation de plan de la surface de la deuxième région.

6. Élément semi-conducteur selon l'une des revendications 1 à 4,
dans lequel la surface de la première région comprend un plan cristallin comprenant une orientation de plan identique à une orientation de plan de la surface de la deuxième région.

7. Élément semi-conducteur selon l'une des revendications 1 à 6, comprenant en outre :
une première électrode disposée dans la première région et la deuxième région de la première surface.

8. Élément semi-conducteur selon la revendication 7,
dans lequel la première électrode est une électrode de type n.

9. Élément semi-conducteur selon l'une des revendications 1 à 8,
dans lequel
l'élément semi-conducteur comprend en outre une deuxième électrode disposée sur la deuxième surface.

10. Élément semi-conducteur selon l'une des revendications 1 à 9,
dans lequel la surface de la première région prend l'orientation de plan (000-1).

11. Élément semi-conducteur selon l'une des revendications 1 à 10,
dans lequel la surface de la deuxième région prend l'orientation de plan (000-1).

12. Élément semi-conducteur selon l'une des revendications 1 à 11,
dans lequel la première surface comprend la deuxième région et une pluralité des premières régions prennent en sandwich la deuxième région.

13. Élément semi-conducteur selon la revendication 7 ou 8,
dans lequel, dans une région de contact entre la première électrode et la deuxième région, une superficie d'un plan cristallin comprenant l'orientation de plan (000-1) ou l'orientation de plan (1-100) est plus petite qu'une superficie d'un plan cristallin comprenant une orientation de plan différente de l'orientation de plan (000-1) et de l'orientation de plan (1-100), et
la partie évidée comprend une pluralité de plans cristallins d'orientations de plan mutuellement différentes.

14. Élément semi-conducteur selon l'une des revendications 1 à 13,
dans lequel la première région comprend en outre une superficie rugueuse.

15. Procédé de fabrication d'un élément semi-conducteur (S), le procédé comprenant les étapes suivantes :
la préparation d'un substrat (1) ;
la formation d'un masque (2) sur une première surface (1a) du substrat tout en exposant une région (E) devant servir de point de départ de la croissance d'une couche semi-conductrice (3) avant de former la couche semi-conductrice,
la formation de la couche semi-conductrice (3) comprenant du nitrure de gallium sur la région exposée de la première surface du substrat ;
le retrait du masque de façon à ce que la couche semi-conductrice comprenne une partie saillante (9) ; et
le pelage de la couche semi-conductrice, y compris la partie saillante, du substrat en appliquant une force externe à la couche semi-conductrice et au substrat,
dans lequel, lors du pelage de la couche semi-conductrice du substrat, la couche semi-conductrice est pelée de telle sorte qu'une surface de pelage forme un plan cristallin comprenant une orientation de plan différente d'une orientation de plan (000-1) et d'une orientation de plan (1-100).

16. Procédé de fabrication de l'élément semi-conducteur selon la revendication 15,
dans lequel, lors du pelage de la couche semi-conductrice du substrat, la couche semi-conductrice est pelée en même temps qu'une partie du substrat reliée à la couche semi-conductrice.

17. Procédé de fabrication de l'élément semi-conducteur selon la revendication 16,
dans lequel, lors du pelage de la couche semi-conductrice du substrat, la couche semi-conductrice est pelée de telle manière qu'une partie de la couche semi-conductrice reste sur le substrat.

18. Procédé de fabrication de l'élément semi-conducteur selon l'une des revendications 15 à 17,
dans lequel, d'une surface du masque, une surface sur laquelle croît la couche semi-conductrice comporte des aspérités.

19. Procédé de fabrication de l'élément semi-conducteur selon l'une des revendications 15 à 18, dans lequel
la couche semi-conductrice est formée par croissance épitaxiale de la couche semi-conductrice à partir du substrat,
la couche semi-conductrice comprend une première surface comprenant une première région et une deuxième région adjacente à la première région,
dans lequel la deuxième région est la surface de pelage formée lorsque la couche semi-conductrice est pelée du substrat.

20. Élément semi-conducteur selon la revendication 1,
dans lequel la partie saillante comprend une première région en saillie et une deuxième région en saillie avec une concentration d'impuretés plus faible que la première région en saillie.

21. Élément semi-conducteur selon la revendication 20,
dans lequel la première région de projection est située à une pointe par rapport à la deuxième région de projection.
